(19) Europäisches Patentamt / European Patent Office / Office européen des brevets

(11) EP 2 184 378 A1

(12) EUROPEAN PATENT APPLICATION
published in accordance with Art. 153(4) EPC

(43) Date of publication:
**12.05.2010 Bulletin 2010/19**

(21) Application number: **08792613.5**

(22) Date of filing: **21.08.2008**

(51) Int Cl.:
***C23C 14/24*** *(2006.01)* ***D04H 1/42*** *(2006.01)*
***G02B 1/10*** *(2006.01)* ***G02B 1/11*** *(2006.01)*

(86) International application number:
**PCT/JP2008/064892**

(87) International publication number:
**WO 2009/028389 (05.03.2009 Gazette 2009/10)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **28.08.2007 JP 2007221480**

(71) Applicant: **Hoya Corporation**
**Tokyo 161-8525 (JP)**

(72) Inventors:
- **MITSUISHI, Takeshi**
  **Tokyo 161-8525 (JP)**
- **TAKAHASHI, Yukihiro**
  **Tokyo 161-8525 (JP)**

(74) Representative: **Albrecht, Thomas**
**Kraus & Weisert**
**Patent- und Rechtsanwälte**
**Thomas-Wimmer-Ring 15**
**80539 München (DE)**

# (54) EVAPORATION SOURCE, PROCESS FOR PRODUCING OPTICAL MEMBER, AND OPTICAL MEMBER

(57) An evaporation source for supporting an organic material for vapor deposition which comprises a nonwoven fabric constituted with a fiber comprising silicon oxide, wherein thermal conductivity of the nonwoven fabric is 0.01 to 1.0 $Wm^{-1}K^{-1}$, a process for producing an optical member comprising heating the evaporation source to vapor deposit the organic material for vapor deposition on the surface of an optical member, and an optical member produced in accordance with the process. A material for vapor deposition can be vapor deposited stably with small change in the temperature, a vapor deposited film having uniform thickness and concentration can be formed, and an optical member exhibiting excellent performance of the vapor deposited film can be produced at a small cost.

Fig. 1

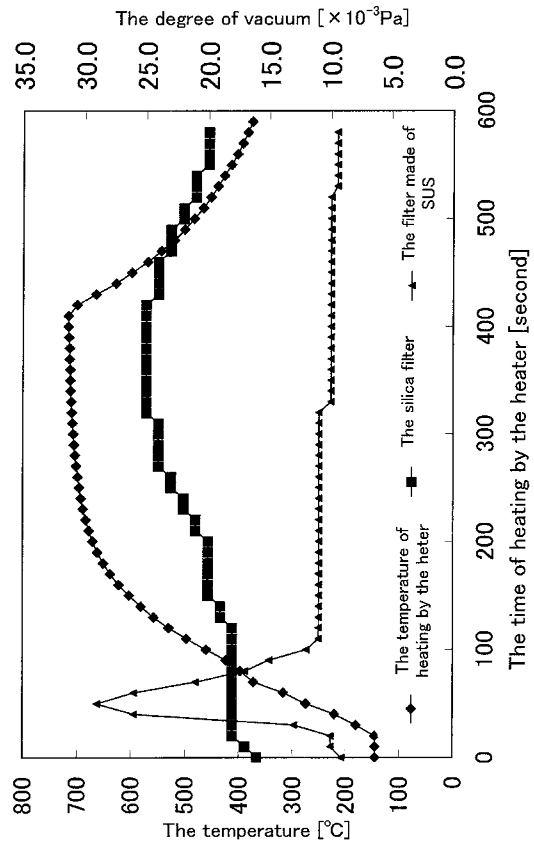


EP 2 184 378 A1

## Description

### TECHNICAL FIELD

The present invention relates to an evaporation source, a process for producing an optical member and an optical member and, more particularly to an evaporation source which enables a material for vapor deposition to be vapor deposited stably with small change in the temperature, can form a vapor deposited film having uniform thickness and concentration and can produce an optical member exhibiting excellent performance of the vapor deposited film at a small cost, a process for producing an optical member using the evaporation source and an optical member.

### BACKGROUND ART

When a film is formed by vapor deposition of an organic material for vapor deposition to an optical member such as a plastic lens, an evaporation source for supporting the organic material for vapor deposition is used.
As the evaporation source used in an apparatus for vapor deposition, an evaporation source which is not vaporized by itself and exhibits small change in the rate of evaporation (the rate of vapor deposition) between the initial and final periods of the vapor deposition is preferable. To achieve approximately the same rate of evaporation at the initial and final periods of evaporation, it is preferable that the evaporation source has a sufficient ability to support a raw material for vapor deposition.
A raw material for vapor deposition occasionally contains impurities although the content of the impurities may be small. In this case, the concentration of the impurities is increased by repeated operations of vapor deposition. The impurities are frequently materials having high boiling points and materials which are not easily removed by cleaning the evaporation source. Moreover, there is the possibility that the cleaning treatment of the evaporation source causes decrease in the ability of the evaporation source to support the raw material for vapor deposition or difficulty in maintaining the uniformity of the rate of evaporation. From the above standpoint, it is the general practice that the evaporation source is used as a consumption material. As long as the evaporation source is used as a consumption material, it is preferable that the evaporation source is an inexpensive material and easily treated for disposal.
As the technology concerning the evaporation source, inventions described in the following Patent References 1 and 2 are disclosed.
In Patent Reference 1, it is disclosed that an organic substance for forming a coating film (a material for vapor deposition) is used by impregnating an evaporation source which is a block of a metal in the fiber form. It is described that the effective component alone can be vapor deposited stably using a small amount of electric power by using the above evaporation source. In Patent Reference 1, the material for vapor deposition is supported on a metal fiber.
In Patent Reference 2, it is disclosed that an evaporation source which is a material having a great thermal conductivity is used as the supporting material. The technology disclosed in Patent Reference 2 is a technology in which an organic compound having a poor thermal conductivity is attached to a supporting material having an excellent thermal conductivity so that even the organic compound having a small thermal conductivity can be heated rapidly.
The evaporation sources described in Patent References 1 and 2 have excellent thermal conductivity. Since the material for vapor deposition removes heat from the metal fiber when the material is evaporated and leaves the metal fiber, heat control of the evaporation source is difficult when the material for vapor deposition is supported on the metal fiber having excellent thermal conductivity. Another drawback arises in that, when a material having excellent thermal conductivity is heated with a material having excellent thermal conductivity, controlling heat at the initial period of vapor deposition when the material for vapor deposition is supported in an excessive amount and at the final period of vapor deposition when the material for vapor deposition is supported in a small amount with stability becomes difficult. Therefore, it is difficult that a vapor deposited film is formed uniformly.

[Patent Reference 1] Japanese Patent Application Laid-Open No. Heisei 6(1994)-340966
[Patent Reference 2] Japanese Patent Application Laid-Open No. 2001-335920

### DISCLOSURE OF THE INVENTION

[Problems to be Overcome by the Invention]

The present invention has been made to overcome the above problems and has an object of providing an evaporation source which enables a material for vapor deposition to be vapor deposited stably with small change in the temperature, can form a vapor deposited film having uniform thickness and concentration and can produce an optical member exhibiting excellent performance of the vapor deposited film at a small cost, a process for producing an optical member using the evaporation source and an optical member.

[Means for Overcoming the Problems]

As the result of intensive studies by the present inventors to achieve the above object, it was found that the above object could be achieved by using a nonwoven fabric constituted with a fiber comprising silicon oxide having a small thermal conductivity as the material for supporting an organic material for vapor deposition. The present invention has been completed based on the knowledge.
The present invention provides an evaporation source for supporting an organic material for vapor deposition which comprises a nonwoven fabric constituted with a fiber comprising silicon oxide, wherein thermal conductivity of the nonwoven fabric is 0.01 to 1.0 $Wm^{-1}K^{-1}$, a process for producing an optical member comprising heating the evaporation source to vapor deposit an organic material for vapor deposition on a surface of an optical member, and an optical member produced in accordance with the process.

THE EFFECT OF THE INVENTION

When an optical member is produced using the evaporation source of the present invention, a material for vapor deposition can be vapor deposited stably with small change in the temperature, a vapor deposited film having uniform thickness and concentration can be formed, and an optical member exhibiting excellent performance of the vapor deposited film can be produced at a small cost.

BRIEF DESCRIPTION OF THE DRAWINGS

Figure 1 shows a diagram exhibiting the change in the temperature of a heater and the pressure at the inside of a chamber versus the time of heating a nonwoven fabric in the present invention and in a conventional technology.

THE MOST PREFERRED EMBODIMENT TO CARRY OUT THE INVENTION

The evaporation source of the present invention is an evaporation source for supporting an organic material for vapor deposition which comprises a nonwoven fabric constituted with a fiber comprising silicon oxide, wherein the thermal conductivity of the nonwoven fabric is 0.01 to 1.0 $Wm^{-1}K^{-1}$ and preferably 0.01 to 0.8 $Wm^{-1}K^{-1}$.
The evaporation source of the present invention comprises, as the material for supporting the organic material for vapor deposition, a nonwoven fabric constituted with a fiber comprising silicon oxide having about the same thermal conductivity as the thermal conductivity of the organic material for vapor deposition. Therefore, the evaporation source exhibits a great effect of heat storage, and the change in the temperature of the evaporation source itself can be suppressed even when heat is removed by evaporation of the material for vapor deposition. As the result, the vapor deposition can be conducted stably under easy heat control. Moreover, even when organic materials having different boiling points are present as a mixture, formation of uneven thickness of the vapor deposited film and uneven dispersion of the material for vapor deposition, which are caused by the difference in vapor deposition between the materials of vapor deposition, can be suppressed since local heating is suppressed.
Since a nonwoven fabric having a small thermal conductivity is used, rapid elevation of temperature in the initial period of heating is suppressed when the evaporation source of the present invention is used. Therefore, degradation of the material for vapor deposition can be suppressed even when a material for vapor deposition in the solid form is heated during the heating in the vapor deposition. For example, unexpected reactions and scorching can be suppressed since no rapid change takes place in the material for vapor deposition in the initial period of heating.
As the fiber comprising silicon oxide as the material constituting the nonwoven fabric in the evaporation source described above, a fiber comprising silicon oxide having a thermal conductivity of 0.1 to 20 $Wm^{-1}K^{-1}$ is preferable, and a fiber comprising silicon oxide having a thermal conductivity of 0.3 to 10 $Wm^{-1}K^{-1}$ is more preferable. Examples of the fiber comprising silicon oxide include silica fiber (the thermal conductivity: 8 $Wm^{-1}K^{-1}$), glass fiber (the thermal conductivity: 1 $Wm^{-1}K^{-1}$) and mixed fibers of silica and aluminum oxide. Silica fiber and glass fiber are preferable.
The evaporation source comprising silica fiber or glass fiber is inexpensive. Therefore, the evaporation source can be disposed of with ease and exchanged with a fresh evaporation source when residues which cannot be removed are left remaining on the evaporation source, and the cost on vapor deposition can be decreased.
The diameter of the fiber comprising silicon oxide is, in general, 0.1 to 200 $\mu$m and preferably 1 to 20 $\mu$m.
The porosity of the nonwoven fabric is, in general, 70 to 99% and preferably 80 to 96%. In the evaporation source of the present invention, the thermal conductivity can be decreased, and the effect of heat storage can be increased by increasing the porosity of the nonwoven fabric as described above.
The thickness of the nonwoven fabric is, in general, 100 to 2000 $\mu$m and preferably 200 to 1,200 $\mu$m.

In the present invention, "supporting the organic material for vapor deposition on the nonwoven fabric" means the condition such that the organic material for vapor deposition impregnates, coats or covers the nonwoven fabric or is adsorbed to the nonwoven fabric. It is preferable that the organic material for vapor deposition described above forms a coating film on the surface of the fiber comprising silicon oxide constituting the nonwoven fabric. When organic material for vapor deposition described above forms a coating film on the surface of the fiber in the evaporation source, the component of vapor deposition is evaporated from the surface of the fiber continuously until the final period of the vapor deposition. Therefore, the change in the rate of evaporation is suppressed from the initial period to the final period of the vapor deposition, and the formation of a uniform film can be achieved.

Examples of the nonwoven fabric used in the present invention include filter papers comprising borosilicate glass fiber alone such as GA-55, GA-100, GA-200, GB-100R, GB-140, GC-50, GD-120 and GF-75, filter papers having increased strength by adding a binder resin to the borosilicate glass fiber such as GS-25, GC-90, DP-70 and PG-60, and filter papers comprising silica fiber such as QR-100 and QR-200 (all trade names of products manufactured by ADVANTEC TOYO KAISHA, Ltd.); and FINEFLEX (a trade name), $SiO_2$-based fibers and $SiO_2$+$Al_2O_3$-based fibers (manufactured by NICHIAS Corporation).

The organic material for vapor deposition used for the evaporation source and the process for producing an optical member of the present invention is not particularly limited. Examples of the organic material for vapor deposition are shown in the following.

<u>Organosilicon compounds having alkyl groups substituted with fluorine which are represented by general formula (I):</u>

$$X_a\text{-}\overset{\displaystyle R_{3-a}}{\overset{|}{Si}}\text{-}(CH_2)_m\text{-}O\text{-}(CH_2)_n\text{-}Rf\text{-}(CH_2)_{n'}\text{-}O\text{-}(CH_2)_{m'}\text{-}\overset{\displaystyle R_{3-b}}{\overset{|}{Si}}\text{-}X_b \quad \cdots (I)$$

In general formula (I), Rf represents a divalent group having a linear perfluoropolyalkylene ether structure which has a unit represented by the formula $-(C_kF_{2k}O)-$ (k representing an integer of 1 to 6 and preferably 1 to 4, and the arrangement of $(C_kF_{2k}O)$ in the general formula being random) and has no branches. When both of n and n' in general formula (I) represent 0, the ends of the group represented by Rf bonded to the oxygen atom (O) in general formula (I) are not oxygen atom.

In general formula (I), X represents a hydrolyzable group or a halogen atom. When X represents a hydrolyzable group, examples of the group include alkoxy groups such as methoxy group, ethoxy group, propoxy group and butoxy group; alkoxyalkoxy groups such as methoxymethoxy group, methoxyethoxy group and ethoxyethoxy group; alkenyloxy groups such as allyloxy group and isopropenoxy group; acyloxy groups such as acetoxy group, propionyloxy group, butylcarbonyloxy group and benzoyloxy group; ketoxim groups such as dimethylketoxim group, methylethylketoxim group, diethylketoxim group, cyclopentanoxim group and cyclohexanoxim group; amino groups such as N-methylamino group, N-ethylamino group, N-propylamino group, N-butylamino group, N,N-dimethylamino group, N,N-diethylamino group and N-cyclohexylamino group; amido groups such as N-methylacetoamido group, N-ethylacetoamino group and N-methylbenzamido group; and aminoxy groups such as N,N-dimethylaminoxy group and N,N-diethylaminoxy group.

When X represents a halogen atom in the above formula, examples of the halogen atom include chlorine atom, bromine atom and iodine atom.

Among the above groups, methoxy group, ethoxy group, isopropenoxy group and chlorine atom are preferable.

In general formula (I), R represents a monovalent hydrocarbon group having 1 to 8 carbon atoms. When a plurality of the groups represented by R are present, the groups represented by R may be the same with or different from each other. Examples of the group represented by R include alkyl groups such as methyl group, ethyl group, propyl group, butyl group, pentyl group, hexyl group, heptyl group and octyl group; cycloalkyl groups such as cyclopentyl group and cyclohexyl group; aryl groups such as phenyl group, tolyl group and xylyl group; aralkyl groups such as benzyl group and phenetyl group; and alkenyl groups such as vinyl group, allyl group, butenyl group, pentenyl group and hexenyl group. Among the above groups, monovalent hydrocarbon groups having 1 to 3 carbon atoms are preferable, and methyl group is more preferable.

In general formula (I), n and n' each represent an integer of 0 to 2 and preferably 1. The integers represented by n and n' may be the same with or different from each other. m and m' each represent an integer of 1 to 5 and preferably 3. The integers represented by m and m' may be the same with or different from each other.

a and b each represent 2 or 3. From the standpoint of the reactivity in hydrolysis and condensation and adhesion of the

formed coating film, it is preferable that a and b both represent 3.
The molecular weight of the organosilicon compound having alkyl groups substituted with fluorine which is represented by general formula (I) is not particularly limited. From the standpoint of stability and easiness of handling, it is suitable that the number-average molecular weight is 500 to 20,000 and preferably 1,000 to 10,000.
Examples of the organosilicon compound having alkyl groups substituted with fluorine which is represented by general formula (I) include the compounds expressed by the following formulae. However, the organosilicon compound is not limited to the compounds shown as the examples.
$(CH_3O)_3SiCH_2CH_2CH_2OCH_2CF_2CF_2O(CF_2CF_2CF_2O)_1CF_2CF_2CH_2$ $OCH_2CH_2CH_2Si(OCH_3)_3$
$(CH_3O)_2CH_3SiCH_2CH_2CH_2OCH_2CF_2CF_2O(CF_2CF_2CF_2O)_1CF_2CF_2$ $CH_2OCH_2CH_2CH_2SiCH_3(OCH_3)_2$
$(CH_3O)_3SiCH_2CH_2CH_2OCH_2CF_2(OC_2F_4)_p(OCF_2)_qOCF_2CH_2OCH_2$ $CH_2CH_2Si(OCH_3)_3$
$(CH_3O)_2CH_3SiCH_2CH_2CH_2OCH_2CF_2(OC_2F_4)_p(OCF_2)_qOCF_2CH_2O$ $CH_2CH_2CH_2SiCH_3(OCH_3)_2$
$(CH_3O)_3SiCH_2CH_2CH_2OCH_2CH_2CF_2(OC_2F_4)_p(OCF_2)_qOCF_2CH_2C$ $H_2OCH_2CH_2CH_2Si(OCH_3)_3$
$(C_2H_5O)_3SiCH_2CH_2CH_2OCH_2CF_2(OC_2F_4)_p(OCF_2)qOCF_2CH_2OCH_2$ $CH_2CH_2Si(OC_2H_5)_3$
The compound represented by general formula (I) may be used singly or in combination of two or more. Where desired, the organosilicon compound having alkyl groups substituted fluorine and products of partial hydrolysis thereof may be used in combination.

<u>Silane compounds represented by general formula (II):</u>

$$R'\text{-}Si(OR'')_3 \text{ and/or } Si(OR'')_4 \qquad \text{(II)}$$

In general formula (II), R' represents an organic group, examples of which include alkyl groups having 1 to 50 carbon atoms and preferably having 1 to 10 carbon atoms (such as methyl group, ethyl group and propyl group), epoxyethyl group, glycidyl group and amino group. The organic group represented by R' may be substituted.
In general formula (II), R" represents an alkyl group having 1 to 48 carbon atoms (such as methyl group, ethyl group and propyl group). It is preferable that R" represents methyl group or ethyl group.
Examples of the silane compound represented by general formula (II) include compounds expressed by structural formulae: $(C_2H_5O)_3SiC_3H_6NH_2$, $(CH_3O)_3SiC_3H_6NH_2$, $(C_2H_5O)_4Si$ and $(C_2H_5O)_3Si\text{-}O\text{-}Si(OC_2H_5)_3$. However, the silane compound is not limited to the compounds shown as the examples.
Specific examples among the above silane compounds include KY130 and kp801 (trade names, manufactured by SHIN-ETSU CHEMICAL Co., Ltd.), OPTOOL DSX (a trade name, manufactured by DAIKIN INDUSTRIES, Ltd.) and x24-9201M (a trade name, manufactured by SHIN-ETSU CHEMICAL Co., Ltd.). However, the silane compound is not limited to the compounds shown as the examples as long as the compound can be supported on the fiber comprising silicon oxide.

<u>Organosilicon compounds having fluorine represented by general formula (III):</u>

$$A_\alpha Z^1Q\text{-}Rf^1\text{-}(Q\text{-}Z^2\text{-}Q\text{-}Rf^1)_x\text{-}QZ^1A_\alpha \qquad \text{(III)}$$

In general formula (III), $Rf^1$ represents a perfluorooxyalkylene group, $Z^1$ represents the single bond or an organic group having 1 to 15 silicon atoms and having a valence of 2 to 9, $Z^2$ represents a divalent polyorganosiloxylene group having 2 to 100 silicon atoms, Q represents a group having 2 to 12 carbon atoms and having a valence of 2 to 9 which may have oxygen atom and/or nitrogen atom, the plurality of groups represented by Q may be the same with or different from each other, $\alpha$ represents an integer of 1 to 8, x represents an integer of 0 to 5, and A represents a group represented by the following general formula IV):

$$-C_dH_{2d}SiR^1_{3-c}X^1_c \qquad \text{(IV)}$$

In general formula (IV), $R^1$ represents an alkyl group having 1 to 4 carbon atoms or phenyl group, and $X^1$ represents a hydrolyzable group, examples of which include alkoxy groups having 1 to 10 carbon atoms such as methoxy group, ethoxy group, propoxy group and butoxy group; oxyalkoxy groups having 2 to 10 carbon atoms such as methoxymethoxy group and methoxyethoxy group; acyloxy groups having 1 to 10 carbon atoms such as acetoxy group; alkenyloxy groups having 2 to 10 carbon atoms such as isopropenoxy group; and halogeno groups such as chloro group, bromo group and iodo group. Among the above groups, methoxy group, ethoxy group, isopropenoxy group and chloro group are

preferable. c represents 2 or 3, and d represents an integer of 0 to 6.

Examples of the organosilicon compound having fluorine which is represented by general formula (IV) include compounds having the structures expressed by the following formulae (1) and (2). However, the organosilicon compound is not limited to the compounds shown as the examples.

(1)

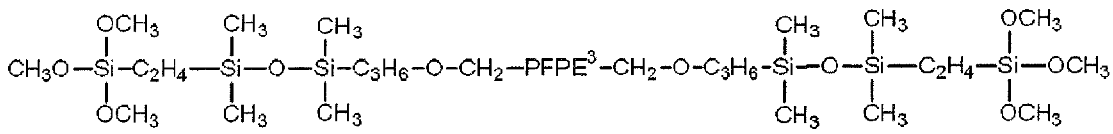

PFPE$^3$ :

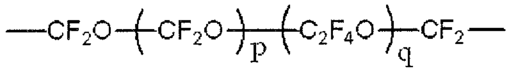

$p = 25$、$q = 35$ (as the average value)

(2)

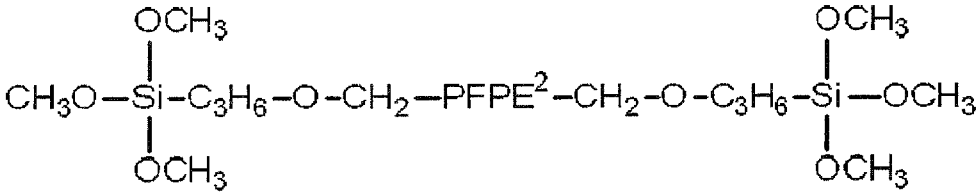

PFPE$^2$ :

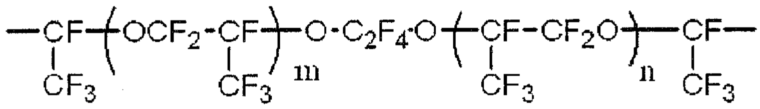

$m + n = 33$ (as the average value)

Where necessary, the organic material for vapor deposition may be used in the form of a solution in which a hydrofluoroether, a solvent and a perfluoroether having no silicon atoms are mixed. In this case, for example, the fiber comprising silicon oxide is placed into a tray made of stainless steel (SUS), impregnated with the solution, and dried, and the organic material for vapor deposition is supported on a nonwoven fabric.

The process for producing an optical member of the present invention is a process which comprises heating an evaporation source described above to vapor deposit the organic material for vapor deposition on the surface of an optical member. In the process of the present invention, the time of heating is, in general, 1 to 20 minutes and preferably 4 to 15 minutes. When the time of heating is 1 to 20 minutes, a uniform vapor deposited film can be formed on the surface of the optical member without uneven vapor deposition.

In the process for producing an optical member of the present invention, the organic material for vapor deposition is vapor deposited on an optical member by heating (by using a halogen heater, a resistance heater or an electron gun) under a reduced pressure to form the vapor deposited film described above. When the heating is conducted by using a halogen heater or a boat placed under the material, the rate of increase in the temperature is milder, for example, than that in the process in which the material is injected into a filter made of SUS. Therefore, the thickness is controlled excellently during the formation of the thin film, and decomposition of the material for vapor deposition can be prevented. As the result, excellent accuracy of the thickness of the film can be achieved, and a thin film exhibiting the proper properties of the material for vapor deposition can be formed.

In the present invention, the degree of vacuum in the apparatus for vacuum vapor deposition during the vapor deposition is not particularly limited. The degree of vacuum is, in general, $1.33 \times 10^{-1}$ to $1.33 \times 10^{-6}$ Pa ($10^{-3}$ to $10^{-8}$ Torr) and

preferably $6.66\times10^{-1}$ to $8.00\times10^{-4}$ Pa ($5.0\times10^{-3}$ to $6.0\times10^{-6}$ Torr) so that a thin film having a uniform thickness is obtained.

In the present invention, the specific temperature for heating the material for vapor deposition is different depending on the type of the material for vapor deposition and the condition of the vacuum in the vapor deposition. It is preferable that the vapor deposition is conducted at a temperature in the range from the temperature at which the vapor deposition of the material for vapor deposition starts under the desired degree of vacuum to a temperature which is not higher than the decomposition temperature. The temperature at which the vapor deposition of the material for vapor deposition starts means the temperature at which the vapor pressure of the solution containing the material for vapor deposition described above is the same as the degree of vacuum. The decomposition temperature means the temperature at which 50% by mass of the material for vapor deposition described above is decomposed in one minute under the atmosphere of nitrogen in the absence of substances reactive with the compound.

Since the nonwoven fabric having the thermal conductivity described above is used in the evaporation source of the present invention, the phenomenon of excessive heating of the evaporation source due to elevation of the temperature of the heater is suppressed. Therefore, it is made possible that the film of the material for vapor deposition is formed at a temperature lower than the decomposition temperature.

To confirm the effect of the evaporation source of the present invention, the heating was conducted using a heater, and the pressure at the inside of the chamber was measured. In the present experiment, KY130 was used as the organic material for vapor deposition. The pressure at the inside of the chamber was measured while the organic material for vapor deposition was supported on the nonwoven fabric of a silica fiber used in the present invention or on a conventional filter made of SUS. Figure 1 shows a diagram exhibiting the result of the experiment described above. In the diagram shown in Figure 1, the horizontal axis shows the time of heating by the heater. The right vertical axis shows the temperature of the heater, and the left vertical axis shows the pressure (the degree of vacuum) at the inside of the chamber. Filled rhombic points in the diagram show the temperature of heating by the heater, which shows the temperature of the heater versus the time. Filled square points show the degree of vacuum at the inside of the chamber versus the time of heating with the heater when the nonwoven fabric (the silica filter) of the present invention was used as shown by the legend. The filled triangular points show the degree of vacuum at the inside of the chamber versus the time of heating with the heater when the conventional filter made of SUS was used as shown by the legend. The nonwoven fabric used in the present invention and the filter made of SUS were each placed in a tray made of SUS and heated.

As shown in Figure 1, when the conventional heater made of SUS was used, the pressure at the inside of the chamber was rapidly increased at the initial stage of the heating by the heater and, then, decreased. It is shown that the heating proceeded rapidly and the film was formed before the heating by the heater was completed when the filter made of SUS was used. In contrast, when the nonwoven fabric described in the present invention was used, the pressure at the inside of the chamber was increased gradually and decreased gradually. This result is obtained since the temperature did not follow the heating by the heater directly but was elevated and lowered gradually when the nonwoven fabric described in the present invention was used.

Since no rapid change in the temperature takes place when the evaporation source of the present invention is used, the vapor pressure during the film formation can be controlled stably, and the uniform formation of the film can be achieved without unevenness. When the evaporation source of the present invention is used, the material for vapor deposition is attached to the surface of the substrate without decomposition, and the characteristics of the material for vapor deposition are not adversely affected.

Examples of the optical member of the present invention include spectacle lenses, camera lenses, optical filters attached to displays of word processors and window glasses of automobiles. The optical member of the present invention is suitable as a plastic lens and, in particular, a plastic lens for spectacles among these optical members.

Examples of the material for the optical member used in the present invention include optical substrates made of plastics such as homopolymers of methyl methacrylate, copolymers of monomer components comprising methyl methacrylate and at least one other monomer, homopolymers of diethylene glycol bisallylcarbonate, copolymers of monomer components comprising diethylene glycol bisallylcarbonate and at least one other monomer, copolymers containing sulfur, copolymers containing halogens, polycarbonates, polystyrenes, polyvinyl chloride, unsaturated polyesters, polyethylene terephthalate and polyurethanes; and optical substrates made of inorganic glasses. The above substrates may comprise a hard coat layer on the substrates. Examples of the hard coat layer include cured films comprising organosilicon compounds and acrylic compounds.

In the present invention, the optical member may have an antireflection film formed thereon, and the organic material for vapor deposition may be vapor deposited on the antireflection film.

The antireflection film means, for example, a single layer film or a multi-layer film formed with $ZrO_2$ $SiO_2$, $TiO_2$, $Ta_2O_5$, $Y_2O_3$, $MgF_2$, $Al_2O_3$ or the like (preferably having a film of $SiO_2$ as the outermost layer) or a colored film of $CrO_2$ or the like (preferably having a film of $SiO_2$ as the outermost layer) to decrease the reflection on the surface of an optical substrate such as a lens. In the present invention, it is preferable that a layer comprising silicon dioxide as the main component is disposed as the outermost layer of the antireflection film. The layer comprising silicon dioxide as the main component means a layer substantially composed of silicon dioxide or a hybrid layer composed of silicon dioxide,

aluminum oxide and organic compounds. It is preferable that the antireflection film is formed in accordance with the vapor deposition process.
In the present invention, the vapor deposited film formed by vapor deposition of the organic material for vapor deposition is not particularly limited. Examples of the vapor deposited film include water repellent films, antireflection films and anticlouding films.

## EXAMPLES

The present invention will be described more specifically with reference to examples in the following. However, the present invention is not limited to the examples.
Physical properties of the plastic lenses obtained in Examples and Comparative Examples were evaluated in accordance with the following methods of evaluation.

(1) Appearance

The presence or the absence of unevenness of color of interference and cloudiness was examined by visual observation in a dark room under a fluorescent light, and it was evaluated whether the plastic lens had appearance suitable for use as a spectacle lens.

(2) Abrasion resistance (change in haze)

Using an abrasion tester of the reciprocal friction type manufactured by SHINTO SCIENTIFIC Co., Ltd., the surface of a plastic lens having a water repellent film was treated by the abrasion tester in 50 reciprocal movements under a load of 4 kg using a sand rubber eraser (manufactured by LION OFFICE PRODUCTS Corp.; INK & PENCIL ERASER). The haze value was measured using a haze meter MH-150 manufactured by MURAKAMI COLOR RESEARCH LABORATORY, and the change in the haze value was obtained.

(3) Static contact angle to water

Using a contact angle meter (manufactured by KYOWA INTERFACE SCIENCE Co., Ltd.; the CA-D type), a droplet of water having a diameter of 2 mm at 25°C was formed at the tip of a needle. The formed droplet of water was brought into contact with the uppermost portion of the convex face of a lens, and a liquid droplet was formed. The angle between the formed liquid droplet and the surface was measured and used as the static contact angle. When the radius of the droplet of water (the radius of the portion where the droplet of water contacted the surface of the lens) is represented by r and the height of the droplet of water is represented by h, the static contact angle θ can be obtained in accordance with the following equation:

$$\theta = 2\times\tan^{-1}(h/r)$$

The measurement of the static contact angle was conducted within 10 seconds after the droplet of water was brought into contact with the surface of the lens so that the error of measurement caused by vaporization of water is held as small as possible.

Example 1

A silica filter QR-100 (a trade name; manufactured by ADVANTEC TOYO KAISHA, Ltd.; the diameter: 21 mm; the thickness: 0.5 mm; the diameter of the fiber: 1 to 10 μm; the average porosity: 92% (85 to 92%)) placed in a tray made of SUS (the inner diameter: 21 mm; the thickness: 1 mm; the depth: 3 mm) was impregnated with 0.30 ml of an agent for the water repelling treatment KY130 (a trade name: manufactured by SHIN-ETSU CHEMICAL Co., Ltd.). The product of impregnation was heated in a drying oven at 50°C for 1 hour and, then, set at the inside of an apparatus for vacuum vapor deposition.
Using a halogen heater, the temperature was elevated to 700°C in 4 minutes and, then, from 700°C to 850°C in 4 minutes, and a water repellent film was formed on a plastic lens having an antireflection film. The luminous reflectance of the obtained lens was 0.4%. The results of evaluation conducted in accordance with the methods described above in (1) to (3) are shown in Table 1.

Example 2

A silica filter QR-100 placed in a tray made of SUS (the inner diameter: 21 mm; the thickness: 1 mm; the depth: 3 mm) was impregnated with 0.40 ml of an agent for the water repelling treatment kp801 (a trade name: manufactured by SHIN-ETSU CHEMICAL Co., Ltd.). The product of impregnation was heated in a drying oven at 50°C for 1 hour and, then, set at the inside of an apparatus for vacuum vapor deposition.
Using a halogen heater, the temperature was elevated to 600°C in 2 minutes and, then, to 700°C in 5 minutes, and a water repellent film was formed on a plastic lens having an antireflection film. The luminous reflectance of the obtained lens was 0.4%. The results of evaluation conducted in accordance with the methods described above in (1) to (3) are shown in Table 1.

Comparative Example 1

A water repellent film was formed on a plastic lens having an antireflection film in accordance with the same procedures as those conducted in Example 1 except that a filter made of SUS was used in place of the silica filter QR-100. The luminous reflectance of the obtained lens was 0.4%. The results of evaluation conducted in accordance with the methods described above in (1) to (3) are shown in Table 1.

Comparative Example 2

A water repellent film was formed on a plastic lens having an antireflection film in accordance with the same procedures as those conducted in Example 2 except that a filter made of SUS was used in place of the silica filter QR-100. The luminous reflectance of the obtained lens was 0.4%. The results of evaluation conducted in accordance with the methods described above in (1) to (3) are shown in Table 1.
Table 1

| | Material for vapor deposition | Contact angle of water | Appearance | Abrasion resistance: change in haze value |
|---|---|---|---|---|
| Example 1 | KY130 | 108° | good | +3.5 |
| Example 2 | kp801 | 110° | good | +6.0 |
| Comparative Example 1 | KY130 | 108° | good | +4.5 |
| Comparative Example 2 | kp801 | 110° | good | +7.5 |

As shown in Table 1, in comparison with the water repelling film formed by using a conventional filter made of SUS, the water repelling film formed by using the silica filter exhibited smaller change in the haze value, i.e., improved abrasion resistance, although the contact angle of water was the same.

INDUSTRIAL APPLICABILITY

As described specifically in the above, when the optical member is produced by using the evaporation source of the present invention, the material for vapor deposition can be vapor deposited stably with small change in the temperature, the vapor deposited film having uniform thickness and concentration can be formed, and the optical member exhibiting excellent performance of the vapor deposited film can be produced at a small cost. The optical member is suitable as the plastic lens for spectacles, in particular.

**Claims**

**1.** An evaporation source for supporting an organic material for vapor deposition which comprises a nonwoven fabric constituted with a fiber comprising silicon oxide, wherein thermal conductivity of the nonwoven fabric is 0.01 to 1.0 $Wm^{-1}K^{-1}$.

**2.** An evaporation source according to claim 1, wherein thermal conductivity of the fiber comprising silicon oxide is 0.1

to 20 $Wm^{-1}K^{-1}$.

**3.** An evaporation source according to claim 1, wherein porosity of the nonwoven fabric is 70 to 99%.

**4.** An evaporation source according to claim 1, wherein the fiber comprising silicon oxide is silica fiber or glass fiber.

**5.** An evaporation source according to claim 1, wherein the organic material for vapor deposition forms a coating film on a surface of the fiber comprising silicon oxide constituting the nonwoven fabric.

**6.** A process for producing an optical member comprising heating an evaporation source described in claim 1 to vapor deposit the organic material for vapor deposition on a surface of an optical member.

**7.** A process for producing an optical member according to claim 6, wherein time of the heating is 1 to 20 minutes.

**8.** A process for producing an optical member according to claim 6, wherein the optical member has an antireflection film formed thereon, and the organic material for vapor deposition is vapor deposited on the antireflection film.

**9.** A process for producing an optical member according to claim 6, wherein the organic material for vapor deposition is vapor deposited to form a water repellent film on the optical member.

**10.** An optical member produced in accordance with a process described in claim 6.

Fig. 1

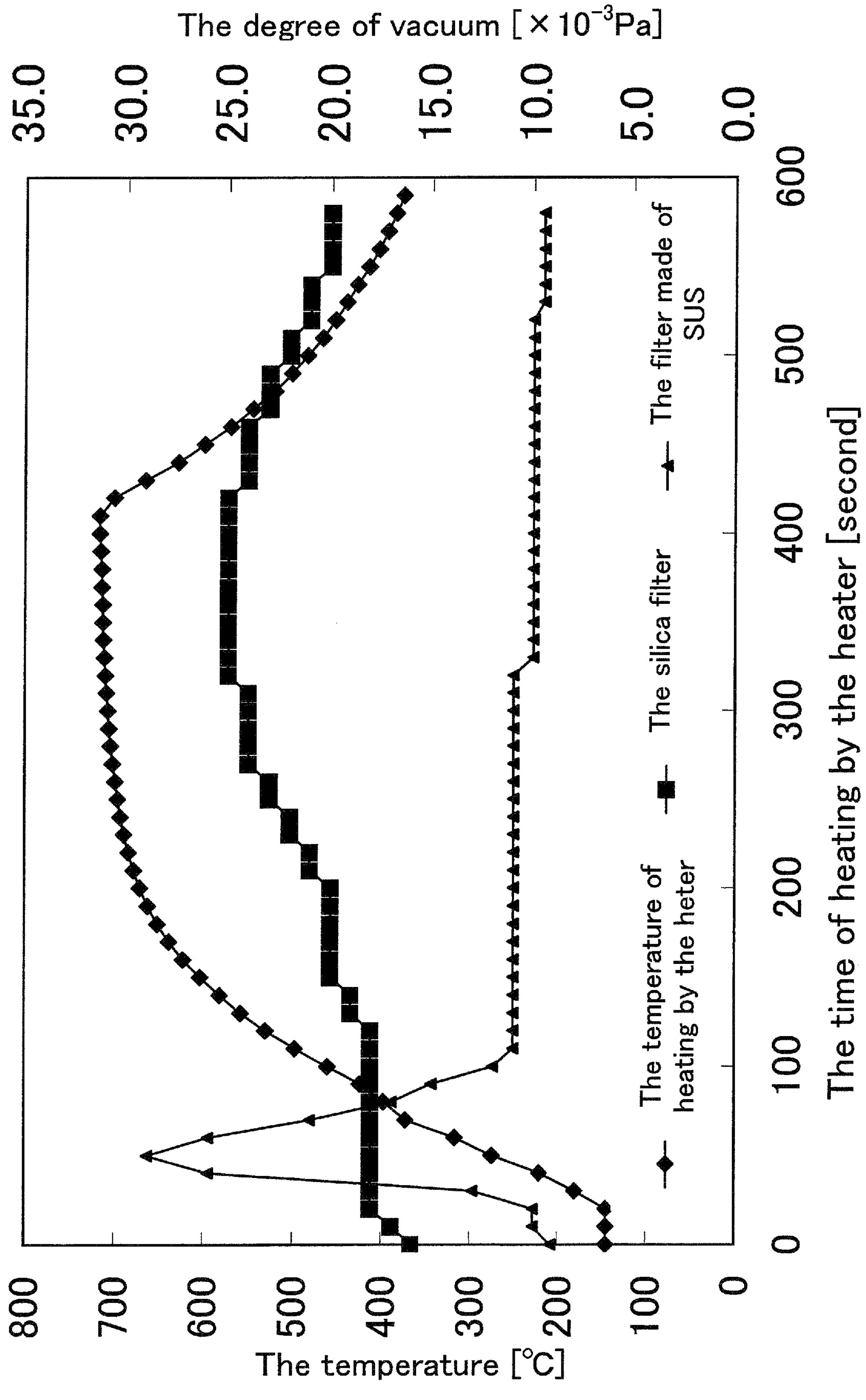
The degree of vacuum [×10$^{-3}$Pa]
35.0
30.0
25.0
20.0
15.0
10.0
5.0
0.0
800
700
600
500
400
300
200
100
0
The temperature [℃]
0
100
200
300
400
500
600
The time of heating by the heater [second]
The temperature of heating by the heter
The silica filter
The filter made of SUS

**INTERNATIONAL SEARCH REPORT**

International application No.
PCT/JP2008/064892

A. CLASSIFICATION OF SUBJECT MATTER
*C23C14/24*(2006.01)i, *D04H1/42*(2006.01)i, *G02B1/10*(2006.01)i, *G02B1/11*(2006.01)i

According to International Patent Classification (IPC) or to both national classification and IPC

B. FIELDS SEARCHED

Minimum documentation searched (classification system followed by classification symbols)
C23C14/00-14/58, D04H1/42, G02B1/10, G02B1/11

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2001-183503 A (Toray Industries, Inc.), 06 July, 2001 (06.07.01), Claims 1 to 5; Par. Nos. [0013] to [0034]; examples (Family: none) | 1-10 |
| A | JP 2000-321401 A (Toray Industries, Inc.), 24 November, 2000 (24.11.00), Claims 1 to 3; Par. Nos. [0012] to [0018], [0031] to [0037] (Family: none) | 1-10 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 September, 2008 (22.09.08) | 07 October, 2008 (07.10.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*


### Patent documents cited in the description

- JP HEISEI61994340966 B
- JP 2001335920 A